# EUROPEAN PATENT APPLICATION

(11) **EP 2 017 962 A1**
(43) Date of publication of application: **21.01.2009**
(21) Application number: 07468008.3
(22) Date of filing: 16.07.2007
(51) Int. Cl.: H03J 1/00, H04N 7/18

(54) **A remote controller having a digital magnifier**

(71) Applicant: Univerza v Ljubljani FAKULTETA ZA ELEKTROTEHNIKO, 1000 Ljubljana (SI)
(72) Inventor: Guna, Joze, 1420 Trbovlje (SI); Bester, Janez, 4201 Zgornja Besnica (SI); Jenko, Mojca, 1290 Grosuplje (SI); Leskovec, Janez, 1231 Ljubljana (SI); Kos, Andrej, 4273 Blejska Dobrava (SI)
(74) Representative: Ivancic, Bojan

(57) **Abstract**

The present invention discloses a television and/or multimedia remote control device having a digital magnifier for enhancing user's ability to read printed matter, and a complementary receiving unit. A remote controller (20) is disclosed comprising a housing (21) having at least one command input means (22) preferably located on the top side of the housing, a camera (23) attached to the housing, preferably located on the bottom side of the housing, illuminators (24) that are located near the camera (23), and a camera lid (25). The remote controller (20) is adapted to transmit remote control commands to target remote controlled devices, e.g. television, DVD player, SAT receiver, computer, etc. The remote controller (20) is additionally adapted to transmit still images and/or video streams of the printed matter taken by the camera (23) to the receiving unit. The receiving unit is arranged to modify the received still images and/or video streams into a video signal and to forward the video signal to a target display device, e.g. a television, which is adapted to display the images of the printed matter on its screen.

## Description

### FIELD OF THE INVENTION

The present invention relates generally to remote control devices, and more specifically to television and/or multimedia remote control devices having a digital magnifier for enhancing user's ability to read printed matter.

### BACKGROUND OF THE INVENTION

Remote controllers for remotely operating televisions, computers, DVD players, amplifiers, etc., are well known. Such remote controllers typically comprise a hand-held housing upon which one or more command input means, typically buttons, are located. Such remote controllers are commonly utilized with program listings and the like to which a user refers in order to determine which channel to view, listen to, or record. The entries of such program listings and the like are frequently printed in comparatively small type, making reading thereof difficult, particularly for the elderly and those with impaired eyesight.

As such, it would be beneficial to provide means for enhancing a user's ability to read the printed matter without needing to apply appropriate magnifying glass or spectacles.

### SUMMARY OF THE INVENTION

The present invention comprises a remote controller comprising a housing having at least one command input means preferably located on the top side of the housing, and a camera attached to the housing, preferably located on the bottom side of the housing. The remote controller is adapted to transmit the images taken by the camera preferably to a receiving unit, which is adapted to optionally process the received images and to forward the images to a display device, preferably a television, computer screen, or any other multimedia display, which is adapted to display the received images. The camera may be integrally formed with the housing of the remote controller or removably attached thereto. Optionally, one or more illuminators are positioned near the camera and are configured so as to enhance the quality of the images taken by the camera. Optionally, a camera lid is integrated into the housing to protect the camera when not in use, and optionally in its open position to function as a footing for the remote controller. Optionally, the remote controller is adapted to transmit a continuous video stream. Optionally, the remote controller is adapted to transmit still images, e.g. upon user's request and/or at predefined time intervals. Optionally, the remote controller is adapted to process video streams and/or still images prior to transmit in order to increase their quality. Optionally, the remote controller is adapted to encrypt video streams and/or still images prior to transmitting them to the receiving unit in order to provide for secure data transfer. Optionally, the remote controller is adapted to compress video streams and/or still images prior to transmitting them to the receiving unit in order to reduce the necessary communication channel bandwidth. Optionally, the remote controller is adapted to transmit both the remote control commands and video streams and/or still images using a single transmitter. Optionally, the remote controller is adapted to transmit remote control commands using a first transmitter and to transmit video streams and/or still images using a second transmitter. Optionally, the remote controller is a universal remote controller capable of remotely controlling multiple devices, e.g. televisions, receivers, DVD players, amplifiers, computers, etc. Optionally, the universal remote controller is capable of learning new remote control codes. Optionally, the remote controller is adapted to receive functional capability definitions of target remote controlled devices in order to enable the remote controller to be able to remotely control the target remote controlled devices. Optionally, command input buttons of the remote controller are arranged into a plurality of groupings based on their functionality.

The present invention additionally comprises a receiving unit being adapted to receive video streams and/or still images from the remote controller according to the invention, to optionally process the received video streams and/or still images, and to forward them to a target display device. Optionally, the receiving unit is a stand-alone device. Optionally, the receiving unit forms a part of the target display device. Optionally, the receiving unit is adapted to decrypt the received encrypted video streams and/or still images prior to forwarding them to the target display device. Optionally, the receiving unit is adapted to decompress the received compressed video streams and/or still images prior to forwarding them to the target display device. Optionally, the receiving unit is adapted to process video streams and/or still images prior to forwarding them to the target display device in order to increase their quality. Optionally, the receiving unit is adapted to receive remote control commands from the remote controller. Optionally, the receiving unit is adapted to forward the received remote control commands to target remote controlled devices, e.g. televisions, receivers, DVD recorders, amplifiers, computers, etc. Optionally, the receiving unit is adapted to receive functional capability definitions from the target remote controlled devices and to forward these definitions to the remote controller in order to enable the remote controller to be able to remotely control the target remote controlled devices.

### BRIEF DESCRIPTION OF THE DRAWINGS

Fig. 1 illustrates an exemplary embodiment of a remote controller according to the invention, the remote controller comprising command input buttons and a camera, whereby the command input buttons are organized into a plurality of groupings based on their functionality.
Fig. 2 illustrates an exemplary embodiment of a remote controller according to the invention, the remote controller comprising command input buttons, a camera, two illuminators and a camera lid in its possible open position, whereby the command input buttons are organized into a plurality of groupings based on their functionality.
Fig. 3 illustrates an exemplary embodiment of a functional representation of the remote controller according to the invention, whereby two separate transmitters are applied, one for transmitting remote control commands, and one for transmitting still images and/or video streams.
Fig. 4 illustrates an exemplary embodiment of a functional representation of the remote controller according to the invention, whereby a single transmitter is applied for transmitting the remote control commands and also for transmitting still images and/or video streams.
Fig. 5 illustrates an exemplary embodiment of a functional representation of the remote controller according to the invention, whereby still images and/or video streams are processed, compressed, and/or encrypted prior to transmission from the remote controller.
Fig. 6 illustrates an exemplary embodiment of a functional representation of the receiving unit according to the invention, where the received still images and/or video streams are transformed into a video signal prior to forwarding them to a target display device.
Fig. 7 illustrates an exemplary embodiment of a functional representation of the receiving unit according to the invention, whereby the received still images and/or video streams are decrypted, decompressed, and/or processed prior to forwarding them to a target display device.
Fig. 8 illustrates an exemplary embodiment of a system according to the invention, the system comprising a remote controller comprising two separate transmitters, a receiving unit, multiple exemplary target remote controlled devices, and an exemplary target display device, whereby the receiving unit is connected to the target display device via a video signal transmission cable.
Fig. 9 illustrates an exemplary embodiment of a system according to the invention, the system comprising a remote controller comprising a single transmitter, a receiving unit, multiple exemplary target remote controlled devices, and an exemplary target display device, whereby the receiving unit, the exemplary target remote controlled devices, and the exemplary target display device are connected to each other via a bus or a network.

### DETAILED DESCRIPTION OF EXEMPLARY EMBODIMENTS

The detailed description set forth below in connection with the appended drawings is intended as a description of the presently preferred embodiments of the invention, and is not intended to represent the only forms in which the present invention may be constructed and/or utilized.

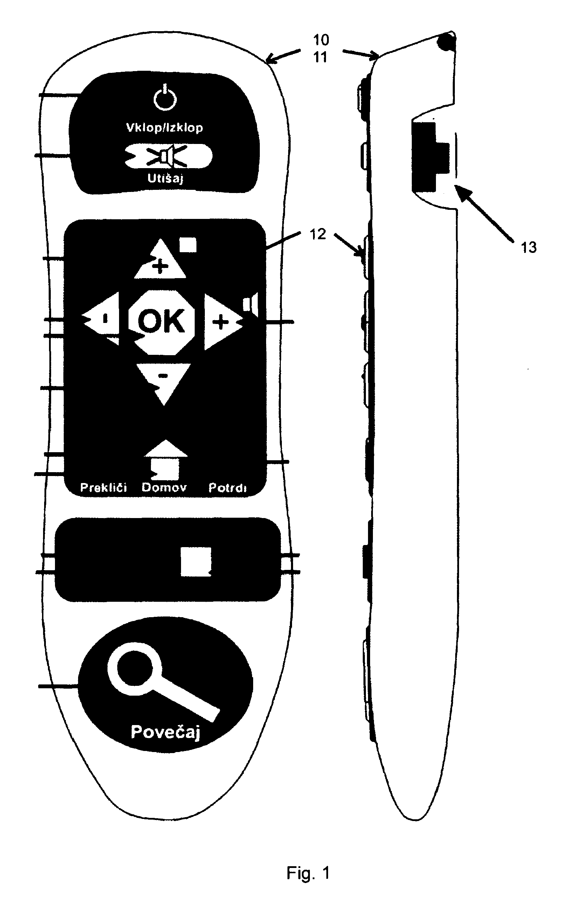

Fig. 1 illustrates an exemplary embodiment of a remote controller according to the invention. The remote controller (10) comprising an exemplary housing (11) having command input buttons (12) located on the top side of the housing, and a camera (13) attached to the bottom side of the housing. Preferably, the remote controller (10) is a hand-held device. It should be understood that the remote controller (10) represents only one of many possible implementations of the invention. It is of course possible to attach camera to any other part of the housing, e.g. on top, on the side, in front, etc. Likewise it is possible to attach the command input buttons to any other part of the housing, e.g. at the bottom, on the side, in front, etc. It should also be noted that the depicted command input buttons are just an example of how commands can be input into the remote controller. Other command input means may be used as a complement and/or replacement for the buttons, e.g. touch pad, joystick, trackball, virtual keyboard (e.g. a virtual keyboard projected on a table in front of the remote controller by means of a laser projection), voice controlled command input means (e.g. by means of voice recognition), etc. The camera (13) is preferably arranged to be able to provide for clear focus on small distances, e.g. from 1 to 6 cm. Optionally, the camera may be arranged to also provide for clear focus on any distances. The camera focus system may be fixed-focus, manual-focus or auto-focus. The camera may be integrally formed with the housing or removably attached thereto. In the latter case the camera may be connected to the remote controller in either wired or wireless manner. The camera is preferably a color camera. Optionally, a B/W camera may be used. Preferably, the camera is a high resolution camera. Preferably, the camera has at least full PAL and/or NTSC resolution. Preferably, the camera is a low power consumption camera, e.g. a CMOS *pin hole* camera.

It should be noted that although in the presently preferred embodiments a camera is applied to acquire still images and/or video streams, other image acquisition means may be applied instead of, or as a complement to the camera. For example, an image scanner may be applied instead of a camera to acquire still images and/or video streams.

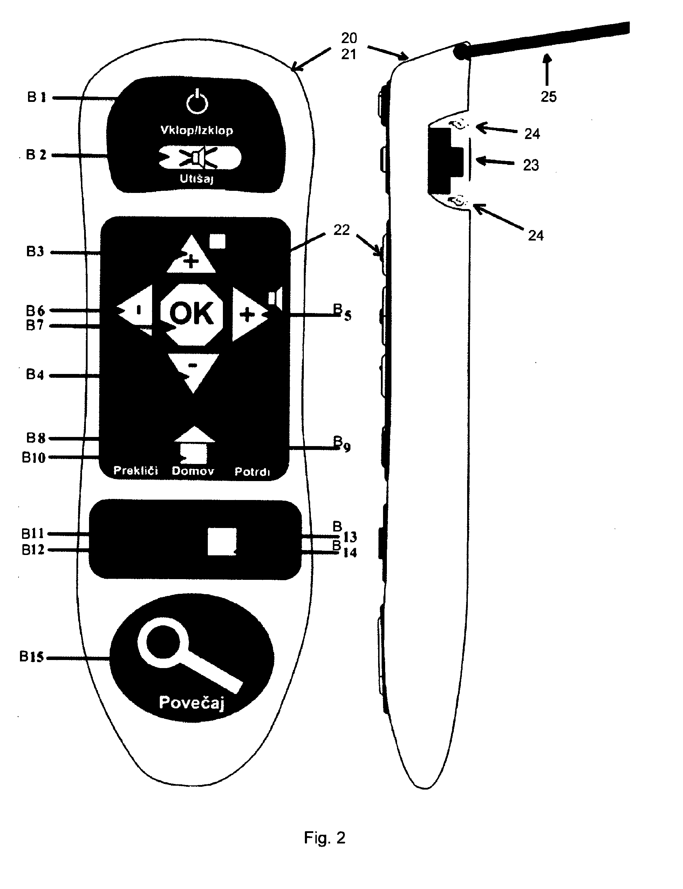

Fig. 2 illustrates an exemplary embodiment of a remote controller according to the invention. The remote controller (20) comprises housing (21) having command input buttons (22) located at the top side of the housing, and a camera (23) attached to the bottom side of the housing.

The remote controller (20) additionally includes one or more illuminators (24), which are located near the camera (23). The illuminators are configured so as to enhance the quality of still images and/or video streams taken by the camera. That it to say, the illuminators are turned on while the camera is taking still images and/or video streams, thus providing for bright, contrast reach, natural color and low noise images. Preferably, the illuminators are arranged to produce non-glare light. Illuminators can be e.g. LED diodes (preferably white LED diodes), fluorescent lamps, or gas discharge lamps, which are all characterized by low power consumption. However, it should be noted that any other type of illuminator may be applied. It should also be noted that the above example of housing (21) with two illuminators (24) represents only one of many possible implementation options, i.e. any number of illuminators may be applied. Also, position of the illuminators according to fig. 2 represents only one of many possible positions, which would be suitable for attaching illuminators to the housing.

The remote controller (20) additionally includes a camera lid (25), depicted on fig. 2 in an open position. The lid in its closed position is arranged to cover up and thus to protect the camera and optionally the illuminators. Optionally, in its open position the lid is arranged to function as a footing for the remote controller, thus providing for a stable distance between the camera and the printed matter, which is to be depicted. Optionally, the lid may be arranged to stop at different open positions, thus giving a user the possibility to choose a desired distance between the camera and the printed matter. Optionally, the camera may be tilt able, either manually and/or automatically, in order to reduce geometric distortions of images taken by the camera. Optionally, an image processor within the remote controller may provide for reduction of geometric distortions of taken images. It should be noted that the example lid (25) represents only one of many possible implementations of a camera lid as regard to position, shape and/or construction. The camera lid may be transparent for visual light, thus being possible to take images while the lid being in its closed position. Optionally, the camera may be protected by a non-movable transparent lid. Optionally, the camera lid may additionally function as an on/off switch for the camera and/or illuminators, or optionally as an on/off switch for the whole digital magnifier system, e.g. the digital magnifier system is switched on when the user moves the lid from its closed position, and is switched off when the user returns the lid into its closed position.

Optionally, the command input buttons of the remote controller are arranged into a plurality of groupings based on their functionality. This is particularly important for the elderly and those with impaired eyesight, since they often have difficulties to recognize the functions of individual buttons on the keypad, especially in a low light environment. The embodiment of the remote controller as illustrated on fig. 2 represents one such arrangement. The command input buttons (22) are arranged into four groups. The first group includes general buttons, which are useful for controlling most target remote controlled devices: on/off (B1) and mute (B2). The second group includes multi purpose buttons: program/menu/page up (B3), program/menu/page down (B4), volume up and menu/page right (B5), volume down and menu/page left (B6), menu/page select (B7), cancel (B8), explicit confirm (B9), and menu/page home (B10). Next group includes buttons for controlling various players/recorders: rewind (B11), play/pause (B12), fast forward (B13), and stop (B14). The last group is reserved for controlling the build-in digital magnifier functionality of the remote controller. The depicted group includes a single button (B15), which is preferably intended to turn the whole digital magnifier system on or off. Optionally, the button (B15) may be used for other purposes, e.g. to command the camera to take a single shot still image, to switch the camera mode between producing a video stream and still images, to modify the time interval between camera taking two consecutive still images, etc. Optionally, the last group may include multiple buttons. Optionally, the remote controller according to the invention is arranged to automatically turn off the digital magnifier system after a predetermined period of time, e.g. after 1 to 10 minutes since button (B15) was last time pressed.

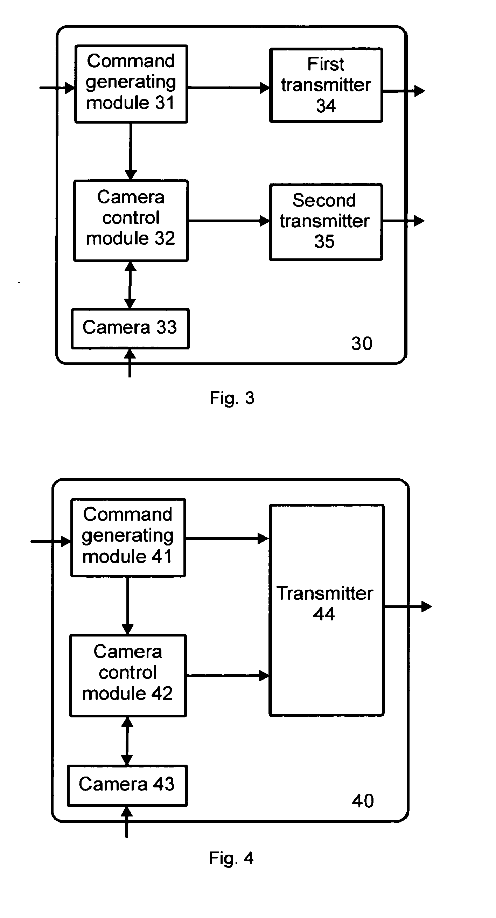

Fig. 3 illustrates an exemplary embodiment of a functional representation of the remote controller according to the invention. In this embodiment the remote controller (30) comprises a command generating module (31), a camera control module (32), a camera (33), a first transmitter (34), and a second transmitter (35). The command generating module is adapted to detect commands when input by a user of the remote controller. The command generating module is adapted to distinct between the input commands for remote control of target remote controlled devices and the input commands for operating the digital magnifier.

The input commands for remote control of target remote controlled devices cause the command generating module (31) to generate appropriate remote control commands for controlling the target remote controlled devices. These remote control commands are then forwarded to the first transmitter, which in turn transmits these remote control commands to the target remote controlled devices. The first transmitter can use any kind of wireless communication means, e.g. infrared (IR), radio frequency (RF), ultrasound, etc. It may either use a proprietary communication protocol or one or more standardized communication protocols, e.g. IrDA, Bluetooth, WLAN, etc. Optionally, the remote controller (30) is a universal remote controller adapted to remotely control a plurality of different target remote controlled devices, e.g. televisions, receivers, DVD players/recorders, amplifiers, computers, etc. Optionally, the universal remote controller includes means for learning new remote control codes of additional target remote controlled devices in order to be able to control them.

The input commands for operating the digital magnifier are relayed by the command generating module to the camera control module (32), which in turn controls operation of the camera. The camera control module is also adapted to receive still images and/or video streams taken by the camera and to forward them to the second transmitter, which in turn transmits them to a receiving unit. The second transmitter can use any kind of wireless communication means, e.g. infrared (IR), radio frequency (RF), ultrasound, etc. It may either use a proprietary communication protocol or one or more standardized communication protocols, e.g. IrDA, Bluetooth, WLAN, etc.

The camera control module (32) is adapted to operate the camera in two different operation modes: continuous and still. It should be noted that the camera control module may also be adapted to support only one mode of operation, i.e. only continuous mode or only still mode of operation.

In the continuous mode of operation the camera is continuously taking images. This would typically be 10 images per second or faster. Such a stream of images is usually called a video stream. It should be noted that video streams with less than 10 images/frames per second rate are also possible. In the continuous mode of operation the camera control module continuously forwards the video stream received from the camera to the second transmitter, which in turn continuously transmits it to the receiving unit. This gives the user an opportunity to see real time or near real time depiction of the printed matter on the screen of target display device.

In the still mode of operation the camera takes one shot at a time, e.g. upon user's request and/or at some predefined time intervals. The camera control module then forwards each taken image separately to the second transmitter, which in turn transmits it to the receiving unit. A user's request to take an image may e.g. be indicated by user pressing a button on the keypad of the remote controller. The predefined time intervals may take any range. As an example, an interval of 0.5 to 5 seconds would be suitable at least as a preview mode for the printed matter. One advantage of the still mode of operation is lower power consumption, since the camera, the optional illuminators, and the second transmitter are turned on for only a fraction of time. Second advantage of the still mode of operation is a stable image on the screen of the target display device. This is especially important for elderly people, which often have problems with hand trembling. Optionally, the remote controller is adapted to detect when a user is holding and/or moving the remote controller, whereby the remote controller is adapted to reduce the time interval between camera taking two consecutive still images when the user is holding and/or moving the remote controller, and to increase the time interval otherwise. Optionally, the remote controller is adapted to temporarily suspend camera taking still images when the user is not holding and/or moving the remote controller. Optionally, the remote controller is adapted to switch of the digital magnifier system when the user has not held and/or moved the remote controller for a longer period of time, e.g. after 15 minutes of user's inactivity.

Fig. 4 illustrates an exemplary embodiment of a functional representation of the remote controller according to the invention. In this embodiment the remote controller (40) comprises a command generating module (41), a camera control module (42), a camera (43), and a transmitter (44). The main difference from the previous embodiment as depicted on fig. 3 is that the remote controller (40) comprises only one transmitter, which is adapted for both transmitting the remote control commands to the target remote controlled devices, and for transmitting video streams and/or still images taken by the camera to the receiving unit. Optionally, the receiving unit is also one of the target remote controlled devices. The transmitter can use any kind of wireless communication means, e.g. IR, RF, ultrasound, etc. It may either use a proprietary communication protocol or one or more standardized communication protocols, e.g. IrDA, Bluetooth, WLAN, etc. Optionally, both the remote control commands and the still images and/or video streams are transmitted from the remote controller (40) to the receiving unit, which in turn relays the received remote control commands to the target remote controlled devices.

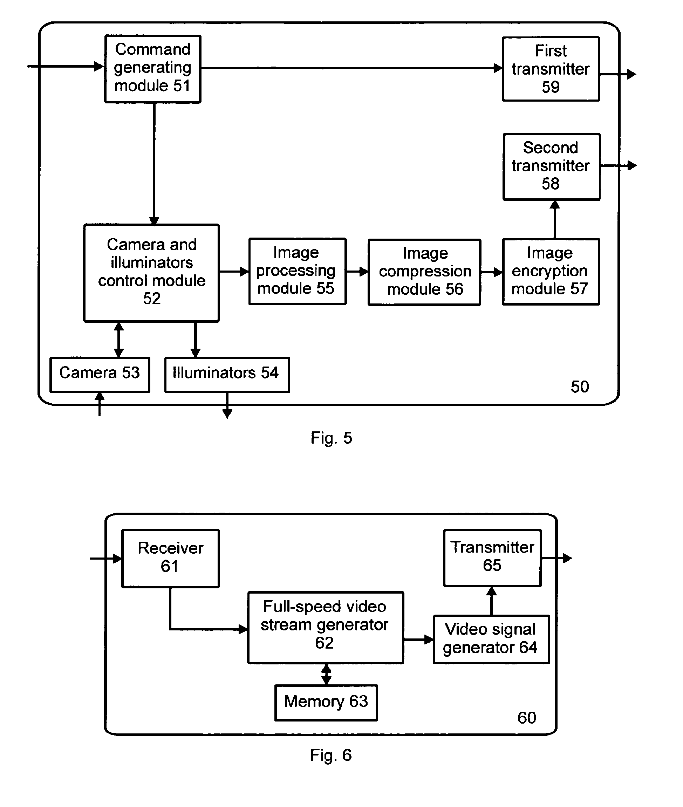

Fig. 5 illustrates an exemplary embodiment of a functional representation of the remote controller according to the invention. In this embodiment the remote controller (50) comprises a command generating module (51), a camera and illuminators control module (52), a camera (53), illuminators (54), an image processing module (55), an image compression module (56), an image encryption module (57), a first transmitter (59), and a second transmitter (58). The difference between this embodiment and the embodiment as represented on fig. 3 is that the remote controller (50) additionally comprises illuminators, and image processing, compression and encryption modules. The illuminators (54) are turned on by the camera and illuminators control module for the time when the camera is taking images, thus providing for better image quality. Optionally, the illuminators may be controlled directly by the camera itself, so that the camera control module need not to also control the illuminators.

The image processing module (55) is adapted to process the incoming still images and/or video streams in a way to increase image quality, e.g. to increase readability of the displayed printed matter. The image processing may e.g. include enhancing image contrast and sharpness, adjusting image colors and brightness, correcting image gamma and geometry, reducing image noise, reducing image trembling in video streams, etc.

The image compression module (56) is adapted to compress the incoming still images and/or video streams in order to reduce the amount of data to be sent from the remote controller to the receiving unit. Consequently, it is possible to use a lower bandwidth second transmitter, e.g. IrDA or Bluetooth. Different compression techniques according to the state-of-the-art may be applied, e.g. JPEG for still images, MJPEG or MPEG for video streams, etc.

The image encryption module (57) is adapted to encrypt the incoming still images and/or video streams in order to provide for secure data transfer from the remote controller to the receiving unit. It is to be expected that people with impaired eyesight would use the digital magnifier functionality that is build into the remote controller according to the invention also for viewing other printed matter, e.g. letters, bills, bank account extracts, etc. These are all private users' documents for which users' privacy should be maintained. As the data from the remote controller is sent in a wireless manner, it is generically exposed to possible other observers. It is the task of the image encryption module to prevent such data exposure. Different encryption techniques according to the state-of-the-art may be applied.

It should be noted that the remote controller as depicted on fig. 5 represents only one of many possible remote controller embodiments. For example, the image processing, compression and encryption modules may be arranged in any order. It is possible that the remote controller includes only some of these modules. It is also possible to join different modules together, e.g. in order to perform image compression and encryption at the same time. It is also possible to combine these modules with other remote controller modules, e.g. encryption and/or compression module may be part of the second transmitter. Optionally, the remote controller is arranged to send and/or receive information regarding to these modules to/from the receiving unit. Optionally, the remote controller is arranged to exchange and/or negotiate information regarding to these modules with the receiving unit. Typically, the exchange and/or negotiation phase includes deciding which encryption algorithm will be used and possibly includes exchange of encryption/decryption keys between the remote controller and the receiving unit. Also, a decision may be made during this phase about what compression algorithm is to be used and which image processing should be performed at which device. This is important in order to be able to properly control the operation of these modules in such a way that the receiving unit will be able to correctly decrypt, decompress, and/or additionally process the still images and/or video streams received from the remote controller. Optionally, module parameters are fixed set in advance and need not to be exchanged and/or negotiated between the remote controller and the receiving unit.

Fig. 6 illustrates an exemplary embodiment of a functional representation of the receiving unit according to the invention. In this embodiment the receiving unit (60) comprises a receiver (61), a full-speed video stream generator (62), a memory (63), a video signal generator (64), and a transmitter (65). The receiver is adapted to receive video streams and/or still images from the remote controller according to the invention. The received video streams and/or still images are then forwarded to the full-speed video stream generator.

The full-speed video stream generator (62) is adapted to produce video streams with either 25 frames per second (e.g. for PAL systems) or 30 frames per second (e.g. for NTSC systems), based on the incoming video streams and/or still images from the remote controller. Optionally, the full-speed video stream generator may be adapted to produce video streams with other frame rates. It was said before that the video streams produced by the remote controller may only include 10 frames per second or less. The situation is even worse with still images, where a single image is received. The full-speed video stream generator is adapted to generate an appropriate number of additional images i.e. video stream frames in order to fill the gap between the received number of frames per second and the requested output number of frames per second. This may be done by image and/or video frame interpolation, whereby different interpolation techniques according to the state-of-the-art may be applied. One possibility for the interpolation is to simply fill all the subsequent full-speed video stream frames with the last received still image or video frame until new still image or video frame is received from the remote controller. Then this new still image or video frame is used to fill all the subsequent full-speed video stream frames until next still image or video frame is received from the remote controller, etc. This technique is quite simple and may be especially useful for generating full-speed video streams from received still images. The memory (63), which is connected to the full-speed video stream generator, is utilized by the full-speed video stream generator for temporarily storing the received video streams and/or still images from the remote controller, and optionally also for temporarily storing the newly generated full-speed video stream frames. Optionally, the memory may also be connected directly to the receiver, thereby enabling the receiver to directly store the received video streams and/or still images into the memory, thus making them available for subsequent use by the full-speed video stream generator.

The video signal generator (64) is adapted to generate a video signal based on the incoming full-speed video stream. The generated video signal may take different formats, e.g. RGBHV, RGB, Component Video, S-Video, Composite Video, etc. The format of the generated video signal is selected so as to enable the presentation of information on the target display device. The transmitter (65) may be a video signal amplifier, when the target display device is capable of directly receiving video signals from the receiving unit, e.g. via a SCART cable. The transmitter may be an RF modulator capable of modulating the received video signal to a TV channel frequency. This is useful for presenting the information on a target display device, which is not capable to directly receive video signals, e.g. older television devices. Optionally, the receiving unit (60) may form a part of the target display device. In such a case the transmitter (65) is not necessary and may be omitted from the receiving unit.

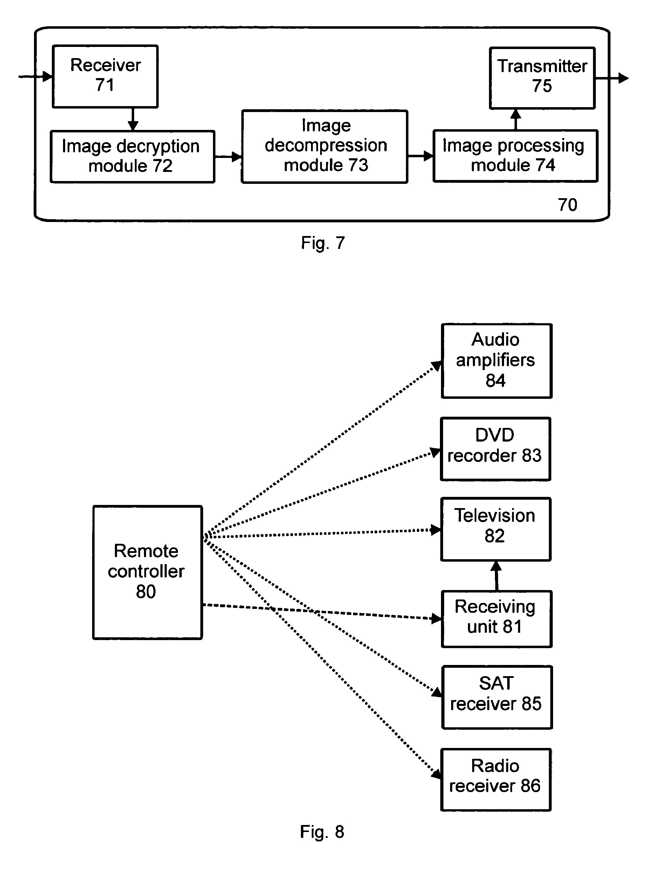

Fig. 7 illustrates an exemplary embodiment of a functional representation of the receiving unit according to the invention. In this embodiment the receiving unit (70) comprises a receiver (71), an image decryption module (72), an image decompression module (73), an image processing module (74), and a transmitter (75). In this exemplary embodiment it is assumed that the target display device is capable to receive and display still images and/or video streams as generated by the remote controller, thus making the conversion of the still images and/or video streams into full-speed video stream and/or video signal superfluous. Optionally, the receiving unit (70) may form a part of the target display device. In such a case the transmitter (75) is not necessary and may be omitted from the receiving unit. Optionally, the receiving unit is adapted connect to a wide area network. In such a case the receiving unit is able to transmit the received remote control commands and/or the received still images and/or video streams over the network, and optionally to receive information from the network.

The image decryption module (72) is adapted to decrypt the received encrypted still images and/or video streams from the remote controller, and the image decompression module (73) is adapted to decompress the received compressed still images and/or video streams from the remote controller. It should be noted that the image decryption and decompression modules may be arranged in any order. It is also possible to combine these modules with other receiving unit modules, e.g. the modules may form a part of the receiver. It is also possible that the receiving unit incorporates only one of these modules, e.g. only decompression module or only decryption module. It is likewise possible that the receiving unit does not include any of these modules. Optionally, the receiving unit is arranged to send and/or receive information regarding to these two modules to/from the remote controller. Optionally, the receiving unit is arranged to exchange and/or negotiate information regarding to these two modules with the remote controller. Optionally, the receiving unit is adapted not to decrypt and/or decompress the received still images and/or video streams. In this case the received information is forwarded in its encrypted and/or compressed form to the target display device, where it is decrypted and/or decompressed before it is displayed. Optionally, the receiving unit is adapted to receive information from the target display device as regard to its capabilities for decryption and/or decompression of the received still images and/or video streams. Optionally, the receiving unit is arranged to exchange and/or negotiate information regarding to these two modules with the target display device.

The image processing module (74) is adapted to process received still images and/or video streams from the remote controller in a way to increase image quality, e.g. to increase readability of the displayed printed matter. The image processing may e.g. include enhancing image contrast and sharpness, adjusting image colors and brightness, correcting image gamma and geometry, reducing image noise, reducing image trembling in video streams, etc. It should be noted that the image processing may be performed either in both the remote controller and the receiving unit, only in the remote controller, only in the receiving unit, or it may not be performed at all. Preferably, when the image processing is performed in both the remote controller and the receiving unit, the two processing modules are adapted to perform complementary image processing steps. Optionally, the receiving unit is arranged to send and/or receive information regarding to image processing to/from the remote controller. Optionally, the receiving unit is arranged to exchange and/or negotiate information regarding to image processing with the remote controller. Optionally, the receiving unit is adapted to receive information from the target display device as regard to its display type and/or its image processing capabilities. Optionally, the receiving unit is arranged to exchange and/or negotiate information regarding to image processing with the target display device. Optionally, the receiving unit is adapted to process the received still images and/or video streams in a way to increase information readability when displayed on the screen of the target display device.

Fig. 8 illustrates an exemplary embodiment of a digital magnifier system according to the invention, the system comprising a remote controller (80) and a receiving unit (81), the remote controller comprising two separate transmitters as depicted on fig. 3. The system further comprises exemplary target remote controlled devices and an exemplary target display device: a television (82), a DVD recorder (83), audio amplifiers (84), a satellite receiver (85), and a radio receiver (86). The receiving unit is preferably connected to the television via a SCART video cable. The remote control commands are transmitted from the remote controller to the target remote controlled devices by using a first transmitter, e.g. a common IR remote control transmitter. Preferably, the remote controller is a universal remote controller capable of learning new remote control codes. The still images and/or video streams are transmitted from the remote controller to the receiving unit using a second transmitter, e.g. an RF transmitter operating at approx. 2.4 GHz transmission frequency and using a proprietary communication protocol. The still images and/or video streams are received by the receiving unit, where they are transformed into a video signal and forwarded to the television for being displayed. Optionally, a video stream is transmitted from the remote controller to the receiving unit in a form of a video signal, preferably an analog video signal, such that no transformation into a video signal is necessary at the receiving unit. Optionally, the receiving unit is adapted to automatically switch on the output video signal when new still images and/or video streams are received from the remote controller. Optionally, the receiving unit is adapted to switch off the output video signal after a predetermined period of time since the last still image and/or video stream has been received from the remote controller. Optionally, the receiving unit is adapted to switch on the output video signal when the digital magnifier at the remote controller is switched on, and to switch off the output video signal when the digital magnifier at the remote controller is switched off. Optionally, the receiving unit is adapted to receive remote control commands sent by the remote controller via the first transmitter.

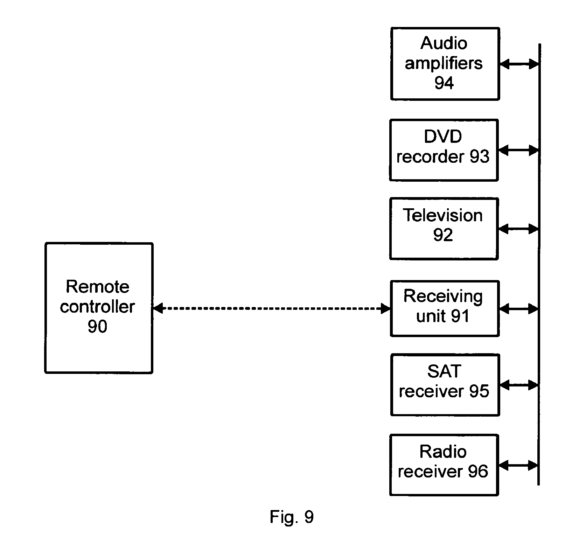

Fig. 9 illustrates an exemplary embodiment of a digital magnifier system according to the invention, the system comprising a remote controller (90) and a receiving unit (91), the remote controller comprising one transmitter as depicted on fig. 4. The system further comprises exemplary target remote controlled devices and an exemplary target display device: a television (92), a DVD recorder (93), audio amplifiers (94), a satellite receiver (95), and a radio receiver (96). In the present example, all devices except the remote controller are connected to a bus or a network, which enables transfer of information between the devices. The bus or the network may use any known wired and/or wireless transmission technology suitable for home networks, e.g. IEEE 1394 (firewire), USB, LAN, WLAN, IrDA, Bluetooth, etc. Information is transmitted from the remote controller to the receiving unit using e.g. IrDA or Bluetooth protocol. This information includes both remote control commands for target remote controlled devices and still images and/or video streams for a target display device. The received remote control commands are relayed by the receiving unit to target remote controlled devices. The received still images and/or video streams are optionally processed at the receiving unit and then forwarded to the target display device; it this example it would be the television. It should be noted that since in this embodiment the still images and/or video streams are transferred from the receiving unit to the target display device using a digital transmission protocol, there is no need to generate a video signal at the receiving unit. Optionally, the receiving unit may relay the received still images and/or video streams unaltered to the target display device. It is then the task of the target display device to optionally decrypt, decompress, and/or process the still images and/or video streams. It is then also the task of the target display device to provide for proper display of the received still images and/or non-full-speed video streams.

Optionally, any target remote controlled device as depicted on fig. 9 is adapted to directly receive information from the remote controller. Thus, the remote control commands may be transmitted directly from the remote controller to the target remote controlled devices. Optionally, the still images and/or video streams may be transmitted directly from the remote controller to the target display device. Optionally, the remote controller (90) is directly connected to the bus or the network, and is thus capable to directly communicate with any other device on the bus or the network.

Optionally, the remote controller (90) is a universal remote controller. Optionally, the remote controller is adapted to receive functional capability definitions of the target remote controlled devices (91-96), thus enabling the remote controller to properly generate and transmit its remote control commands in order to be able to remotely control the target remote controlled devices. A functional capability definition of a target remote controlled device includes a listing of capabilities of the device, the capabilities being represented as abstract feature indicators, whereby a remote control command code is assigned to each abstract feature indicator. A functional capability definition may optionally include other information, e.g. transmission protocol and/or frequency to be used for transmission of remote control commands. The universal remote controller also has an abstract feature indicator assigned to each input command, e.g. to each command input button. Thus, when the universal remote controller receives a functional capability definition from a new target remote controlled device, the remote controller compares the listings of abstract feature indicators and assigns new remote control commands to appropriate input commands e.g. buttons. For example, a universal remote controller receives a functional capability definition of a target remote controlled device, the functional capability definition including an abstract feature indicator named "power on/off" and a corresponding remote control command code. The universal remote controller has an input command button with the same abstract feature indicator, thus the remote controller assigns the received remote control command code to its "power on/off" command input button. Optionally, the receiving unit (91) is adapted to gather functional capability definitions from target remote controlled devices (92-96) and to forward them to the remote controller. Optionally, the remote controller itself is adapted to gather functional capability definitions from target remote controlled devices. Optionally, the remote controller is adapted to advertise its presence to other devices.

Optionally, the target remote controlled devices are adapted to push their functional capability definitions to the remote controller, e.g. upon detecting the presence of the remote controller.

The foregoing illustrates some of the possibilities for practicing the invention. Many other embodiments are possible within the scope of the invention. It is, therefore, intended that the foregoing description in connection with the appended drawings be regarded as illustrative rather than limiting, and that the scope of the invention is given by the appended claims together with their full range of equivalents.

## Claims

1. A remote controller (20, 30, 40) adapted to transmit remote control commands to remotely controlled devices, the remote controller being further adapted to act as a digital magnifier, the remote controller comprising:
- a housing (21),
- a command input means (22),
- a command generating means (31, 41),
- an image acquisition means for acquiring still images and/or video streams (23, 33, 43),
- an image acquisition control means (32, 42),
- a transmission means for transmitting remote control commands, and still images and/or video streams (34, 35, 44).

2. The remote controller according to claim 1, whereby the command input means (22) are located on the top side of the housing (21) and the image acquisition means (23) is attached to the bottom side of the housing, and/or where the command input means (22) comprises one and/or a combination of one or more buttons, touch pads, joysticks, trackballs, virtual keyboards, voice controlled command input means, and/or where the buttons are organized into a plurality of groupings based on their functionality, and/or where the image acquisition means (23) comprises one and/or a combination of a camera or a scanner.

3. The remote controller according to claim 1, further comprising one or more of the following features:
- one or more illuminators (24) located near the image acquisition means (23) for enhancing the quality of still images and/or video streams taken by the image acquisition means,
- an image acquisition means lid (25) to protect the image acquisition means and/or the illuminators.

4. The remote controller according to claim 3, where the image acquisition means lid is further adapted to function as a footing for the remote controller to provide for a stable distance between the image acquisition means and the objects to be magnified, and/or where the image acquisition means lid is further adapted to adjust its open position in order to adjust a distance between the image acquisition means and the objects to be magnified, and/or where the image acquisition means lid is made of a transparent material.

5. The remote controller according to claim 3, where the image acquisition means lid is adapted to switch the digital magnifier on when the lid is moved from its closed position, and to switch the digital magnifier off when the lid is returned into its closed position.

6. The remote controller according to claim 1, where the transmission means comprises two transmitters: a first transmitter (34) adapted to transmit remote control commands, and a second transmitter (35) adapted to transmit still images and/or video streams.

7. The remote controller according to claim 1, where the transmission means comprises a single transmitter (44), which is adapted for transmitting remote control commands, and still images and/or video streams.

8. The remote controller according to claims 6 or 7, where any of the transmitters is adapted to use one or more of the following transmission media: infrared, radio frequency, ultrasound.

9. The remote controller according to claim 8, where any of the transmitters is adapted to use one or more proprietary wireless communication protocols, and/or one or more of the following wireless communication protocols: IrDA, Bluetooth, WLAN.

10. The remote controller of claim 1, where the digital magnifier is adapted to operate in a continuous mode of operation, whereby, when the digital magnifier is turned on, the remote controller is adapted to continuously transmit a video stream.

11. The remote controller of claim 1, where the digital magnifier is adapted to operate in a still mode of operation, whereby, when the digital magnifier is turned on, the remote controller is adapted to take and transmit one still image at a time, either upon receiving an input command or at a predefined time interval.

12. The remote controller of claim 11, where the predefined time interval is selected form a range of 0.5 to 5 seconds.

13. The remote controller of claim 11 or 12, further adapted to detect user holding and/or moving the remote controller, whereby the remote controller is adapted to reduce the predefined time interval when it is detected that user is holding and/or moving the remote controller, and to increase the predefined time interval otherwise.

14. The remote controller of claim 11, further adapted to detect user holding and/or moving the remote controller, whereby the remote controller is adapted to suspend taking and transmitting new still images from the remote controller when it is detected that user is not holding and/or moving the remote controller, and/or whereby the remote controller is adapted to turn off the digital magnifier when it is determined that the user has not been holding and/or moving the remote controller for some time.

15. The remote controller of claim 11, where the remote controller is further adapted to turn on the image acquisition means, optional illuminators, and the still image transmission means each time when new still image is to be taken, to turn off the image acquisition means and the optional illuminators after the new still image is taken, and to turn off the still image transmission means after the new still image is completely transmitted from the remote controller.

16. The remote controller according to claims 10 and 11, whereby the remote controller is adapted to support continuous and/or still mode of operation.

17. The remote controller of claim 10, where the video stream transmission means is adapted to transmit a video stream in a form of a video signal.

18. The remote controller of claim 1, additionally comprising one and/or more of the following features: image acquisition and illuminators control means (52), illuminators (54), image processing means (55), image compression means (56), and/or image encryption means (57).

19. The remote controller of claim 18, where the illuminators are either LED diodes, fluorescent lamps, gas discharge lamps, or a combination thereof.

20. The remote controller of claim 18, where the image processing means (55) is adapted to process still images and/or video streams in order to either enhance image contrast and/or sharpness, adjust image colors and/or brightness, correct image gamma and/or geometry, reduce image noise, and/or reduce image trembling in video streams.

21. The remote controller according to claim 18, further adapted to send and/or receive information regarding to image encryption, image compression and/or image processing to/from a receiving unit and/or at least one target display device, and/or to exchange and/or negotiate information regarding to image encryption, image compression and/or image processing with the receiving unit and/or the at least one target display device.

22. The remote controller according to claim 1, where the remote controller is a universal remote controller capable of learning new remote control codes, and/or where the remote controller is further adapted to receive functional capability definitions of target remote controlled devices, thus enabling the remote controller to control the target remote controlled devices.

23. A system comprising:
- the remote controller (80, 90) according to any one of the preceding claims, and
- a receiving unit (81, 91) adapted to receive still images and/or video streams from the remote controller.

24. The system of claim 23, further comprising at least one target remote controlled device (81-86, 91-96) and/or at least one target display device (82, 92).

25. The system according to claim 23 or 24, the receiving unit (60) being adapted to modify still images and/or video streams received from the remote controller (20, 30, 40) into a form suitable for displaying on at least target display device (82, 92), the receiving unit comprising:
- a receiver (61) adapted to receive still images and/or video streams transmitted from the remote controller (20, 30, 40),
- a full-speed video stream generator (62) adapted to generate a full-speed video stream based on the received still images and/or video streams,
- a video signal generator (64) adapted to generate a video signal based on the generated full-speed video stream,
- a transmitter (65) adapted to transmit the generated video signal to the at least one target display device (82, 92).

26. The system according to claim 25, where the full-speed video stream generator (62) is adapted to produce video streams with either 25 or 30 frames per second.

27. The system according to claim 25 or 26, where the full-speed video stream generator (62) is adapted to produce necessary additional video frames of the full-speed video stream by making copies the last received still image and/or video frame until new still image and/or video frame is received from the remote controller, and/or where the full-speed video stream generator (62) is adapted to store the last received still image and/or video frame in a memory (63).

28. The system according to claim 25, where the video signal generator (64) is adapted to generate one or more of the following video signal formats: RGBHV, RGB, Component Video, S-Video, Composite Video.

29. The system according to claim 23 or 24, where the receiving unit is adapted to receive video streams from the remote controller in a form of a video signal.

30. The system according to claim 25 or 29, where the transmitter (65) is adapted to, prior to transmitting the video signal to at least one target display device, to modulate the video signal to a TV channel radio frequency.

31. The system according to claim 23 or 24, where the receiving unit further comprises one or more of the following means: image decryption means (72), image decompression means (73), and/or image processing means (74).

32. The system according to claim 31, where the image processing means (74) is adapted to either enhance image contrast and/or sharpness, adjust image colors and/or brightness, correct image gamma and/or geometry, reduce image noise, and/or reduce image trembling in video streams.

33. The system according to claim 31, where the receiving unit is further adapted to send and/or receive information regarding to image encryption, image compression and/or image processing to/from the remote controller and/or at least one target display device, and/or to exchange and/or negotiate information regarding to image encryption, image compression and/or image processing with the remote controller and/or the at least one target display device.

34. The system according to claim 23 or 24, the receiving unit being further adapted to forward the received still images and/or video streams to at least one target display device.

35. The system according to claim 23 or 24, the receiving unit being further adapted to receive from the remote controller both remote control commands for target remote controlled devices, and still images and/or video streams, the receiving unit being further adapted to forward the received remote control commands to the target remote controlled devices.

36. The system according to claim 24, where the receiving unit, the at least one target remote controlled device and/or the at least one target display device are adapted to communicate with each other via a bus or a network.

37. The system according to claim 36, where the remote controller is also adapted to connect to the bus or the network.

38. The system according to claim 23 or 24, where the receiving unit is adapted to connect to a wide area network.

39. The system according to claim 23 or 24, where the receiving unit is adapted to gather functional capability definitions of target remote controlled devices and to forward said functional capability definitions to the remote controller.

40. The system of claim 24, where the receiving unit forms a part of the at least one target display device.

41. The system according to any of claims 25, 29, and 34, where at least one target display device is adapted to display the received still images and/or video streams, and/or video signals.

42. A method of operating a remote controller (20, 30, 40), the remote controller also acting as a digital magnifier, the method comprising the following steps:
- generating one or more remote control commands (31, 41) and transmitting the one or more remote control commands (34, 44) after detecting a first input command (22).
- turning on an image acquisition means which is attached to the remote controller (32, 42) and transmitting still images and/or video streams taken by the image acquisition means (35, 44) after detecting a second input command (22).

43. The method according to claim 42, further comprising the step of turning off the image acquisition means and terminating transmission of still images and/or video streams after detecting a third input command (22).

44. The method according to claim 42, further comprising the step of, after detecting the second input command (22), turning on one or more illuminators (24) located near the image acquisition means (23) for enhancing the quality of still images and/or video streams taken by the image acquisition means.

45. The method according to claim 43, further comprising the step of, after detecting the third input command (22), turning off the one or more illuminators.

46. The method according to claim 43, where opening an image acquisition means lid (25) triggers the second input command, and/or closing the image acquisition means lid triggers the third input command.

47. The method according to claim 42, further comprising the step of adjusting the open position of an image acquisition means lid (25) in order to adjust a distance between the image acquisition means and the objects to be magnified.

48. The method according to claim 42, where the one or more remote control commands are transmitted by a first transmitter (34), and the still images and/or video streams are transmitted by a second transmitter (35).

49. The method according to claim 42, where the one or more remote control commands, and the still images and/or video streams are transmitted by a single transmitter (44).

50. The method of claim 48 or 49, where any of the transmitters utilizes one or more of the following transmission media: infrared, radio frequency, ultrasound.

51. The method of claim 50, where any of the transmitters utilizes one or more proprietary wireless communication protocols, and/or one or more of the following wireless communication protocols: IrDA, Bluetooth, WLAN.

52. The method according to claim 42, where the digital magnifier operates in a continuous mode of operation, whereby, when the digital magnifier is turned on, the remote controller is continuously transmitting a video stream.

53. The method according to claim 42, where the digital magnifier operates in a still mode of operation, whereby, when the digital magnifier is turned on, the remote controller takes and transmits one still image at a time, either upon receiving an input command or at a predefined time interval.

54. The method according to claim 53, where the predefined time interval is selected form a range of 0.5 to 5 seconds.

55. The method according to claim 53 or 54, further comprising detecting user holding and/or moving the remote controller, whereby the remote controller reduces the predefined time interval when it is detected that user is holding and/or moving the remote controller, and increases the predefined time interval otherwise.

56. The method according to claim 53, further comprising detecting user holding and/or moving the remote controller, whereby the remote controller suspends taking and transmitting new still images from the remote controller when it is detected that user is not holding and/or moving the remote controller, and/or whereby the remote controller turns off the digital magnifier when it is determined that the user has not been holding and/or moving the remote controller for a predetermined period of time.

57. The method according to claim 53, further comprising turning on the image acquisition means, optional illuminators, and the still image transmission means each time when new still image is to be taken, turning off the image acquisition means and the optional illuminators after the new still image is taken, and turning off the still image transmission means after the new still image is completely transmitted from the remote controller.

58. The method according to claim 52 or 53, whereby the remote controller supports continuous and/or still mode of operation.

59. The method according to claim 52, where the video stream is transmitted in a form of a video signal.

60. The method according to claim 42, further comprising one and/or more of the following steps: processing still images and/or video streams, compressing still images and/or video streams, and/or encrypting still images and/or video streams.

61. The method according to claim 60, where the step of processing of still images and/or video streams encompasses one or more of the following steps: enhancing image contrast and/or sharpness, adjusting image colors and/or brightness, correcting image gamma and/or geometry, reducing image noise, and/or reducing image trembling in video streams.

62. The method according to claim 60, further comprising one or more for the following steps: sending and/or receiving information regarding to image encryption, image compression and/or image processing to/from a receiving unit and/or at least one target display device, and/or exchanging and/or negotiating information regarding to image encryption, image compression and/or image processing with the receiving unit and/or the at least one target display device.

63. The method according to claim 42, where the remote controller receives and stores new remote control codes.

64. The method according to claim 63, further comprising remote controller receiving functional capability definitions of target remote controlled devices in order to enable the remote controller to generate and transmit remote control commands, thus enabling the remote controller to control the target remote controlled devices.

65. A method of operating a system, the method comprising method steps of operating the remote controller according to any of claims 42-64, and the step of receiving still images and/or video streams transmitted from the remote controller.

66. The method according to claim 65, further comprising transmitting the received still images and/or video streams to at least one target display device (82, 92).

67. The method according to claim 65, further comprising:
- generating (62) a full-speed video stream based on the received still images and/or video streams,
- generating (64) a video signal based on the generated full-speed video stream,
- transmitting (65) the generated video signal.

68. The method according to claim 67, where the step of generating a full-speed video stream comprises producing a video stream with either 25 or 30 frames per second.

69. The method according to claim 67 or 68, where the step of generating a full-speed video stream comprises producing necessary additional video frames of the full-speed video stream by making copies of the last received still image and/or video frame until new still image and/or video frame is received from the remote controller, and/or where the full-speed video stream generator (62) stores the last received still image and/or video frame in a memory (63).

70. The method according to claim 67, where the step of generating a video signal comprises generating one or more of the following video signal formats: RGBHV, RGB, Component Video, S-Video, Composite Video.

71. The method according to claim 65, where the received video streams from the remote controller are in a form of a video signal.

72. The method according to claim 67 or 71, where the transmitter (65), prior to transmitting the video signal to at least one target display device, modulates the video signal to a TV channel radio frequency.

73. The method according to claim 65, further comprising one or more of the following steps: decrypting the received still images and/or video streams, decompressing the received still images and/or video streams, and/or processing the received still images and/or video streams.

74. The method according to claim 73, where the step of processing of the received still images and/or video streams encompasses one or more of the following steps: enhancing image contrast and/or sharpness, adjusting image colors and/or brightness, correcting image gamma and/or geometry, reducing image noise, and/or reducing image trembling in video streams.

75. The method according to claim 73, further comprising one or more for the following steps: sending and/or receiving information regarding to image encryption, image compression and/or image processing to/from the remote controller and/or at least one target display device, and/or exchanging and/or negotiating information regarding to image encryption, image compression and/or image processing with the remote controller and/or the at least one target display device.

76. The method according to claim 65, further comprising receiving from the remote controller both remote control commands for target remote controlled devices, and still images and/or video streams, and forwarding the received remote control commands to the target remote controlled devices.

77. The method according to claim 65, where a receiving unit (91), at least one target remote controlled device (91-96) and/or at least one target display device (92) communicate with each other via a bus or a network.

78. The method according to claim 77, where the remote controller also communicates with other devices via the bus or the network.

79. The method according to claim 65, further comprising the step of establishing a connection to a wide area network.

80. The method according to claim 65, further comprising the steps of gathering functional capability definitions of target remote controlled devices, and forwarding said functional capability definitions to the remote controller.

81. The method according to any of claims 65-67 and 71, where at least one target display device displays the received still images and/or video streams, and/or video signal.

82. A computer program product comprising a set of instructions, which, when executed on a computer, cause the computer to perform method steps of any of claims 42-81.

83. A computer readable medium storing thereon the computer program product of claim 82.
